# EUROPÄISCHE PATENTANMELDUNG

(11) **EP 1 271 047 A2**
(43) Veröffentlichungstag der Anmeldung: **02.01.2003**
(21) Anmeldenummer: 02013198.3
(22) Anmeldetag: 15.06.2002
(51) Int. Cl.: F21S 8/10, H01L 33/00

(54) **Leuchte für Fahrzeuge und Verfahren zur Herstellung derselben**

(30) Priorität: 21.06.2001 DE 10129950
(71) Anmelder: Hella KG Hueck & Co., 59552 Lippstadt (DE)
(72) Erfinder: Sachs-D-cker, Gabriele, 59597 Erwitte (DE); Neumann, Cornelius, 33649 Bielefeld (DE); Papenberg, Andr-, 59514 Welver (DE)

(57) **Zusammenfassung**

Leuchte (1) für Fahrzeuge mit einer Mehrzahl von lichtemittierenden Halbleiterchips (3), die auf einer Leiterbahnstruktur (2) angeordnet sind und denen in Abstrahlrichtung ein gemeinsamer Optikkörper (4) vorgelagert ist, wobei der Optikkörper (4) fest mit der Leiterbahnstruktur (2) verbunden und als tragendes Element für die Halbleiterchips (3) und deren Leiterbahnstruktur (2) ausgebildet ist.

Verfahren zur Herstellung einer Leuchte (1) für Fahrzeuge mit einer Mehrzahl von auf einer Leiterbahnstruktur (2) angeordneten lichtemittierenden Halbleiterchips (3) und einem in Abstrahlrichtung vorgelagerten Optikkörper (4), wobei die Halbleiterchips (3) auf der Leiterbahnstruktur (2) kontaktiert und durch Einpassen von Bereichen der Leiterbahnstruktur (2) in entsprechende Optikelemente (13) des Optikkörpers (4) ausgerichtet werden, und dass durch eine transparente Masse (14) die Leiterbahnstruktur (2) fest mit dem Optikkörper (4) verbunden wird.

## Beschreibung

Die Erfindung betrifft eine Leuchte für Fahrzeuge mit einer Mehrzahl von lichtemittierenden Halbleiterchips, die auf einer Leiterbahnstruktur angeordnet sind und denen in Abstrahlrichtung ein gemeinsamer Optikkörper vorgelagert ist.

Die Erfindung betrifft weiterhin ein Verfahren zur Herstellung einer Leuchte für Fahrzeuge mit einer Mehrzahl von auf einer Leiterbahnstruktur angeordneten lichtemittierenden Halbleiterchips und einem in Abstrahlrichtung vorgelagerten Optikkörper.

Zur Beleuchtung in und an Fahrzeugen werden zunehmend Leuchten unter Verwendung von Leuchtdioden als Lichtquellen eingesetzt. Durch die Verwendung von Leuchtdioden in Kombination mit Totalreflexions- und Streuoptiken ist es möglich flache Leuchten bei gleichzeitig gutem optischen Abbildungsverhalten zu schaffen.

Aus der DE 195 07 234 A1 ist eine Leuchte für Fahrzeuge bekannt, die eine Mehrzahl von Leuchtdioden bzw. lichtemittierenden Halbleiterchips aufweist, die auf einer Leiterbahnstruktur angeordnet sind und denen in Abstrahlrichtung ein gemeinsamer Optikkörper vorgelagert ist.

Nachteilig bei der bekannten Leuchte ist, dass die Leiterbahnstruktur mit den Leuchtdioden auf einer Trägerplatte angeordnet ist zu der der gemeinsame Optikkörper exakt positioniert werden muss. Damit gleichbleibende optische Eigenschaften erzielt werden, muss insbesondere verhindert werden, dass sich in Folge von Wärmeausdehnung die Position der Leuchtdioden gegenüber dem Optikkörper verändert. Dies erfordert einen relativ kostenintensiven Aufwand in Konstruktion und Montage.

Aufgabe der vorliegenden Erfindung ist es daher, die bekannte Leuchte so zu verbessern, dass bei geringem Aufwand eine exakte Positionierung zwischen den lichtemittierenden Halbleiterchips und dem Optikkörper gewährleistet wird.

Diese Aufgabe wird erfindungsgemäß in Verbindung mit dem Oberbegriff des Patentanspruches 1 dadurch gelöst, dass der Optikkörper fest mit der Leiterbahnstruktur verbunden und als tragendes Element für die Halbleiterchips und deren Leiterbahnstruktur ausgebildet ist.

Durch die feste Verbindung zwischen Leiterbahnstruktur mit den lichtemittierenden Halbleiterchips und dem Optikkörper wird eine dauerhafte exakte Positionierung der Halbleiterchips erreicht. Da Optikkörper und Leiterbahnstruktur eine Einheit bilden, ist die Montage der Leuchte entsprechend einfach. Vorteilhaft kann weiterhin auf eine gesonderte Trägerplatte für die Leiterbahnstruktur verzichtet werden, was einen noch flacheren Aufbau ermöglicht.

Gemäß einer bevorzugten Ausführungsform der Erfindung ist die Leiterbahnstruktur als ein metallischer Frame mit einer Mehrzahl von Basiselementen ausgebildet auf denen die lichtemittierenden Halbleiterchips elektrisch kontaktiert sind. Das Basiselement weist dabei eine großflächige Kathode auf, auf der der Halbleiterchip aufgebracht ist, und weist eine anschließende Anode auf, die eine Nachbarkathode kontaktiert und die bei thermischer Ausdehnung ein die Ausdehnung ausgleichendes Bauteil bildet. Zu diesem Zweck ist die Anode über eine ein Gelenk bildende Verdünnung mit der Kathode verbunden.

Durch die großflächige Kathode wird die anfallende Betriebswärme des lichtemittierenden Halbleiterchips über die Leiterbahnstruktur abgeführt. Die großflächige Kathode garantiert dabei eine effiziente Wärmespreizung. Eventuelle thermische Spannungen zwischen dem gemeinsamen Optikkörper und dem Frame werden durch die spezielle Form des Frames ausgeglichen. Die als Gelenk fungierende Verdünnung ermöglicht, dass der Frame thermische Bewegungen des tragenden Optikkörpers im Gelenk der Anode federnd ausgleichen kann. Der Frame folgt also der tragenden Optik. Da der Ausgleich durch die Anoden realisiert wird, bleibt der feste Bezug der Kathoden und damit der Lichtquellen bzw. der lichtemittierenden Halbleiterchips zum Optikkörper erhalten. Dadurch wird die Justage von Lichtquelle und Optik sichergestellt.

Nach einer weiteren Ausführungsform der Erfindung weist der Optikkörper eine Mehrzahl von Optikelementen auf, denen jeweils ein Basiselement mit Halbleiterchip zugeordnet ist. Die Halbleiterchips sind dabei jeweils in einem Brennpunkt der Optikelemente angeordnet. Durch die entsprechende Zuordnung von Optikelementen und Basiselementen bzw. deren Halbleiterchips ist eine Erzeugung von spezifischen Lichtverteilungen ohne zusätzliche Sekundäroptiken möglich. Der Optikkörper als tragendes Element weist durch die entsprechende Anordnung seiner Optikelemente einen matrixförmigen Aufbau auf. Dabei ist auch ein einer Kontur, beispielsweise einer Karosserie, folgender Aufbau der Optikscheibe bzw. der Leuchte möglich. Vielfältige stilistische Varianten des Optikaufbaus können dabei realisiert werden. Der Optikkörper bzw. die Optikelemente können dabei ein lichtsammelndes (Reflektor) und lichtverteilendes (Streuoptik) System kombinieren. Der Reflektor kann dabei so gestaltet sein, dass er das vom lichtemittierenden Halbleiterchip bzw. LED-Chip, der sich im Brennpunkt des optischen Systems befindet, emittiertes Licht umlenkt und mittels Totalreflexion oder Verspiegelung sammelt. Als Formen sind beispielsweise Paraboloide, Koni oder Ellipsoide möglich. Die Lichtverteilung kann durch eine auf der Körperoberseite des Optikkörpers angebrachte Streuoptik oder direkt über einen entsprechend geformten Freiformreflektor erzeugt werden.

Auch ist es möglich, auf den Reflektoren eine konvexe oder konkave Kissenoptik aufzubringen. Weiterhin ist es möglich nur das von dem lichtemittierenden Halbleiterchip direkt abgestrahlte Licht zu nutzen und mit einer Streuoptik zu versehen. Auch können so entsprechende Einkoppelelemente für Lichtleitsysteme, z. B. Prismenstäbe aufgebaut werden.

Gemäß einer weiteren bevorzugten Ausführungsform der Erfindung sind die Leiterbahnstruktur und der Optikkörper durch eine transparente Masse miteinander verfugt.

Durch die transparente Masse, z. B. Epoxydharz- oder Acrylatmasse, wird eine stabile Verbindung zwischen der Leiterbahnstruktur mit lichtemittierenden Halbleiterchip und dem Optikkörper erzielt. Durch die transparente Masse wird zudem der Brechungsindex an das Material des Optikkörpers mit einer Brechzahl von ca. 1,3 bis 1,6 angepasst.

Nach einer weiteren bevorzugten Ausführungsform der Erfindung ist die transparente Masse mit einem Konvertierungsmittel versetzt. Durch die Zugabe von Konvertierungsmittel, beispielsweise einem Phosphat, kann Einfluss auf die Farbgebung der Leuchteinheit genommen werden. So kann durch teilweise Umwandlung von emittierter blauer Strahlung eines entsprechenden lichtemittierenden Halbleiterelements bzw. LED-Chips weißes Licht erzeugt werden. Es ist aber auch möglich zwischen der transparenten Masse und dem Optikelement eine Schicht aus einem Konvertierungsmittel anzuordnen.

Gemäß einer weiteren bevorzugten Ausführungsform der Erfindung weist der metallische Frame im Bereich seiner Basiselemente eine Kontur auf, die in die zugeordneten Optikelemente so eingreift, dass die Basiselemente gegenüber den Optikelementen einpassbar und ausgerichtet miteinander verfügbar sind.

Durch die entsprechende dreidimensionale Ausbildung der Basiselemente wird so eine Autojustage der Lichtquellen bzw. der lichtemittierenden Halbleiterelemente in Bezug auf das optische System bzw. der Optikelemente erzielt.

Die besondere dreidimensionale Struktur der Basiselemente ermöglicht also zum einen eine automatische Zentrierung der Basiselemente mit den lichtemittierenden Halbleiterchips und zum anderen einen Ausgleich der Schrumpfung der Fügemasse. Die dreidimensionale Form der Frames garantiert zudem, dass auch nach der Aushärtung der transparenten Masse der lichtemittierende Halbleiterchip und dessen Kontaktdraht sowie die entsprechenden Bereiche der Anode und Kathode vom ausgehärteten Material umschlossen sind und schafft somit eine sichere Verbindung zwischen Frame und Optik.

Weitere Aufgabe der Erfindung ist es, ein Verfahren zur Herstellung der oben beschriebenen Leuchte anzugeben, das eine einfache und sichere Zuordnung bzw. Justierung von Leiterbahnstruktur und vorgelagerten Optikkörper ermöglicht.

Diese Aufgabe wird erfindungsgemäß in Verbindung mit dem Oberbegriff des Patentanspruches 10 dadurch gelöst, dass die Halbleiterchips auf der Leiterbahnstruktur kontaktiert und durch Einpassen von Bereichen der Leiterbahnstruktur in entsprechende Optikelemente des Optikkörpers ausgerichtet werden, und dass durch eine transparente Masse die Leiterbahnstruktur fest mit dem Optikkörper verbunden wird.

Durch das Einpassen von Bereichen der Leiterbahnstruktur in entsprechende Optikelemente des Optikkörpers wird eine einfache und automatische Justierung zwischen Leiterbahnstruktur und Optikelementen erreicht. Dadurch, dass durch eine transparente Masse die Leiterbahnstruktur fest mit dem Optikkörper verbunden wird, wird zudem eine dauerhafte Justierung erreicht. Damit gestaltet sich auch die spätere Montage bzw. der Einbau der Leuchte entsprechend einfach.

Gemäß einer bevorzugten Ausführungsform der Erfindung werden die lichtemittierenden Halbleiterchips mittels Die-Bonden und Draht-Bonden mit der als Frame ausgebildeten Leiterbahnstruktur kontaktiert.

Beim Die-Bonden werden kleine Chips (Dies), hier lichtemittierende Halbleiterchips/ LED-Chips, auf die Leiterbahnstruktur durch Leitkleben oder Löten aufgebracht. Durch Draht-Bonden wird anschließend eine Verbindung zwischen lichtemittierendem Halbleiterchip und der Anode der Leiterbahnstruktur bzw. des Basiselementes hergestellt. Grundsätzlich ist es aber auch möglich, die lichtemittierenden Halbleiterchips mittels der bekannten Flip-Chip-Technik mit der als Frame ausgebildeten Leiterbahnstruktur bzw. den Basiselementen zu kontaktieren.

Nach einer weiteren bevorzugten Ausführungsform der Erfindung erfolgt das Ausrichten von Leiterbahnstruktur und Optikelementen durch Einpassen einer räumlichen Kontur von Basiselementen der Leiterbahnstruktur mit kontaktierten Halbleiterchips in die entsprechenden Optikelemente.

Durch das Einpassen der räumlichen Kontur der Basiselemente in die entsprechenden Optikelemente erfolgt eine automatische Zentrierung bzw. Justierung der Basiselemente und damit der auf den Basiselementen angeordneten lichtemittierenden Halbleiterchips. Die entsprechende räumliche Kontur kann mit einem teilweise tiefgezogenen Frame erreicht werden. Es ist aber auch möglich die räumliche Kontur durch Biegen und Schneiden herzustellen. Grundsätzlich ist es auch möglich, das Ausrichten von Leiterbahnstruktur und Optikelementen mit Hilfe von Justagedornen von Basiselementen der Leiterbahnstruktur, die in entsprechende Ausformungen der Optikelemente greifen, durchzuführen.

Gemäß einer bevorzugten Ausführungsform der Erfindung wird die Leiterbahnstruktur mit dem Optikkörper vergossen oder umspritzt. Neben dem Verkleben bieten sich somit zwei weitere Möglichkeiten der Verbindung von Optikkörper und Leiterbahnstruktur an.

Weitere Einzelheiten der Erfindung ergeben sich aus der nachfolgenden ausführlichen Beschreibung und den beigefügten Zeichnungen, in denen bevorzugte Ausführungsformen der Erfindung beispielsweise veranschaulicht sind.

In den Zeichnungen zeigen:

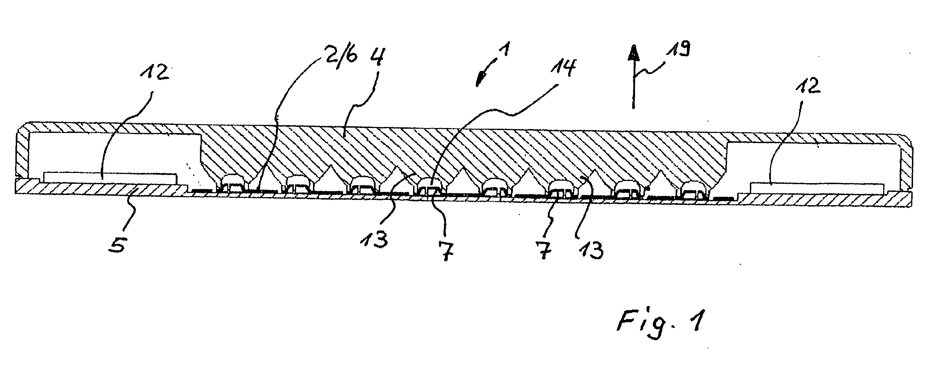

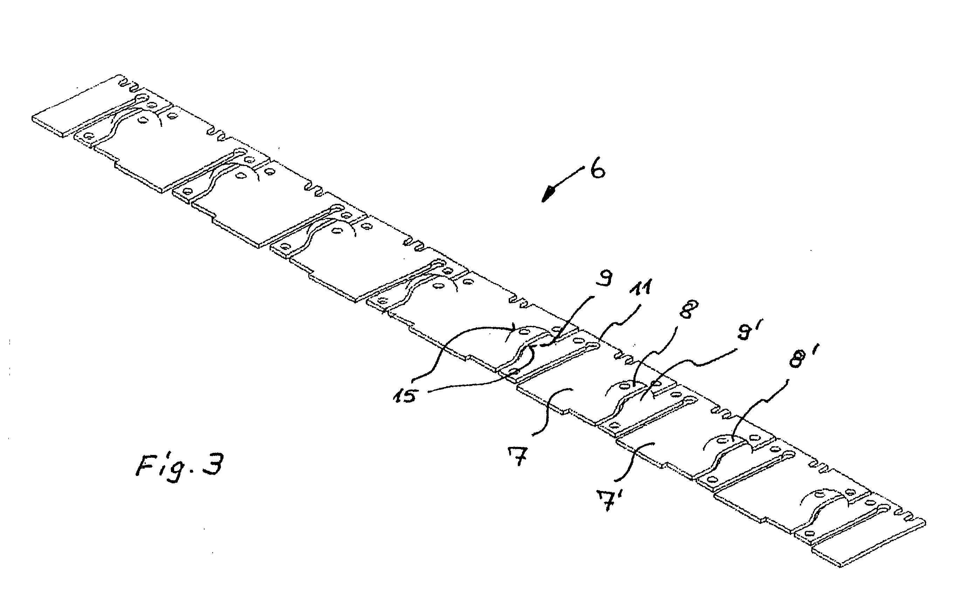

- Figur 1:: Eine Seitenansicht einer Leuchte für Fahrzeuge im Schnitt,
- Figur 2:: eine vergrößerte Prinzipskizze einer Leuchte für Fahrzeuge im Schnitt und vergrößerter Darstellung,
- Figur 3:: eine Draufsicht auf einen teilweise tiefgezogenen Frame,
- Figur 4:: eine Draufsicht auf einen Frame dessen eingepasste Kontur durch Biegen und Schneiden hergestellt wurde,
- Figur 5:: eine Draufsicht auf einen Frame mit Justagedornen zur Justage,
- Figur 6:: eine Draufsicht auf einen weiteren Frame mit Justagedornen zur Justage,
- Figur 7:: eine Seitenansicht eines Optikelementes einer Optikscheibe mit einem lichtsammelnden Reflektor und einer lichtverteilenden Streuoptik im Schnitt,
- Figur 8:: eine Seitenansicht eines weiteren Optikelementes im Schnitt mit einem Freiformreflektor,
- Figur 9:: eine Seitenansicht eines Optikelementes im Schnitt mit einer auf den Reflektoren aufgebrachten konvexen Kissenoptik,
- Figur 10:: eine Seitenansicht eines Optikelementes im Schnitt mit einer auf den Reflektoren aufgebrachten konkaven Kissenoptik,
- Figur 11:: eine Seitenansicht eines Optikelementes mit einer Streuoptik im Schnitt,
- Figur 12:: eine Seitenansicht eines Optikelementes das als Einkoppelelement für ein als Prismenstab ausgebildetes Lichtleitsystem ausgebildet ist im Schnitt,
- Figur 13:: eine räumliche Darstellung einer als Lichtleiste ausgebildeten Leuchte.

Eine Leuchte 1 für Fahrzeuge besteht im Wesentlichen aus einer Leiterbahnstruktur 2 mit lichtemittierenden Halbleiterchips 3, einem Optikkörper 4 und einem Gehäuse 5.

Die Leiterbahnstruktur 2 ist als ein metallischer Frame 6, z.B. ein Stanzgitter, mit einer Mehrzahl von matrixförmig angeordneten Basiselementen 7 ausgebildet. Auf den Basiselementen 7 sind die lichtemittierenden Halbleiterchips 3 bzw. LED-Chips mittels Die-Bonden und Draht-Bonden elektrisch kontaktiert.

Das Basiselement 7 besteht jeweils aus einer großflächigen Kathode 8, auf der der lichtemittierende Halbleiterchip 3 angeordnet ist, und aus einer anschließenden kleinflächigen Anode 9. Die Anode 9 ist mit dem lichtemittierenden Halbleiterchip 3 einer Nachbarkathode 8' eines benachbarten Basiselementes 7' durch eine Drahtbondung 10 elektrisch verbunden. Die Anode 9 ist über eine ein Gelenk bildende Verdünnung 11 mit der Kathode 8 verbunden. Eine Ansteuerung der lichtemittierenden Halbleiterchips 3 erfolgt über eine Ansteuerelektronik 12. Die Ansteuerelektronik 12 kann beispielsweise als eine einfache Widerstands-Vorbeschaltung oder eine Stromkonstanderschaltung realisiert sein. Auch ist eine Integration auf dem Frame 6 mittels Chipdirektverarbeitung möglich.

Der Optikkörper 4 ist ebenfalls matrixförmig aufgebaut und weist eine Mehrzahl von Optikelementen 13 auf, denen jeweils ein Basiselement 7 mit lichtemittierendem Halbleiterchip 3 mit festem Bezug zugeordnet ist. Die lichtemittierenden Halbleiterchips 3 sind jeweils in einem Brennpunkt der zugeordneten Optikelemente 13 angeordnet. Jeweils eine Kathode 8 und eine Anode 9' eines benachbarten Basiselementes 7' sind innerhalb eines zugeordneten Optikelementes 13 kombiniert.

Die Leiterbahnstruktur 2 bzw. der Frame 6 sind durch eine transparente Masse 14 miteinander verfugt und nach einem Aushärtevorgang fest miteinander verbunden. Die Verfugung bzw. Verbindung von Frame 6 und Optikkörper 4 kann durch Verkleben, Vergießen oder Umspritzen erfolgen.

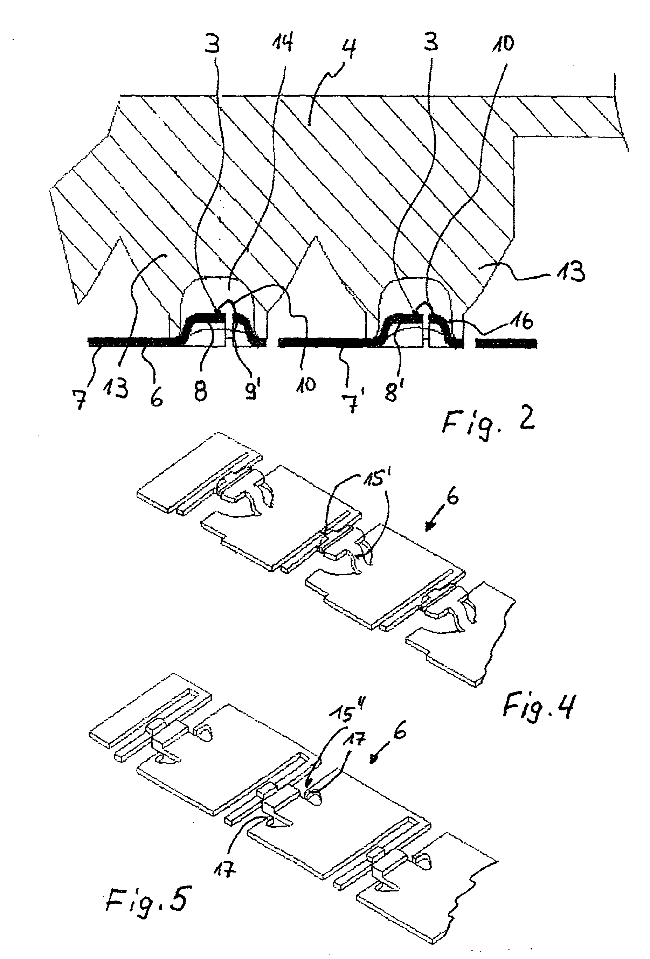

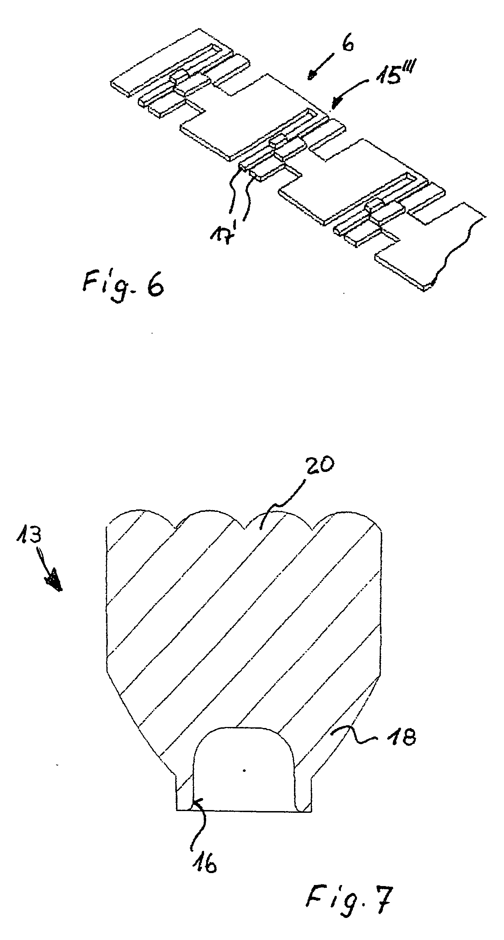

Der metallische Frame 6 weist im Bereich seiner Basiselemente 7, 7' eine Kontur 15 auf, die in die zugeordneten Optikelemente 13 so eingreift, dass die Basiselemente 7, 7' gegenüber den Optikelementen 13 ausgerichtet bzw. automatisch justiert werden. Der Frame 6 von Figur 3 ist teilweise tiefgezogen, so dass seine Kontur 15 in entsprechende Hälse bzw. Ausformungen 16 der Optikelemente 13 eingepasst werden kann. Entsprechend Figur 4 kann die Kontur 15' auch durch Biegen und Schneiden hergestellt werden. Entsprechend den Figuren 5 und 6 kann die Kontur 15" und 15'" zum Einpassen bzw. Justieren Justagedorne 17, 17' aufweisen, die in entsprechende Ausformungen der Optikelemente 13 eingreifen. Der Frame 6 kann streifenförmig aufgebaut sein, so dass bspw. jeweils vier lichtemittierende Halbleiterchips 3 in einer Reihenschaltung kombiniert sind, welche spiegelsymmetrisch zu einer Achterreihe kombiniert werden.

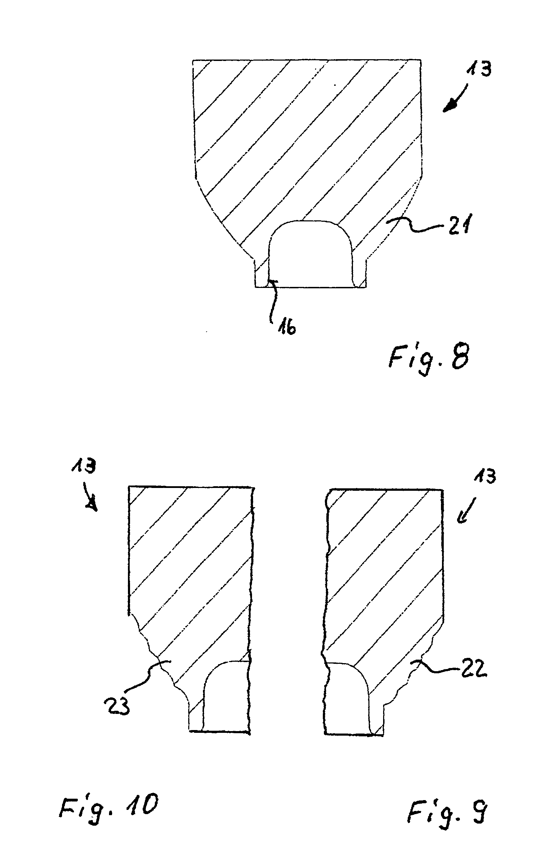

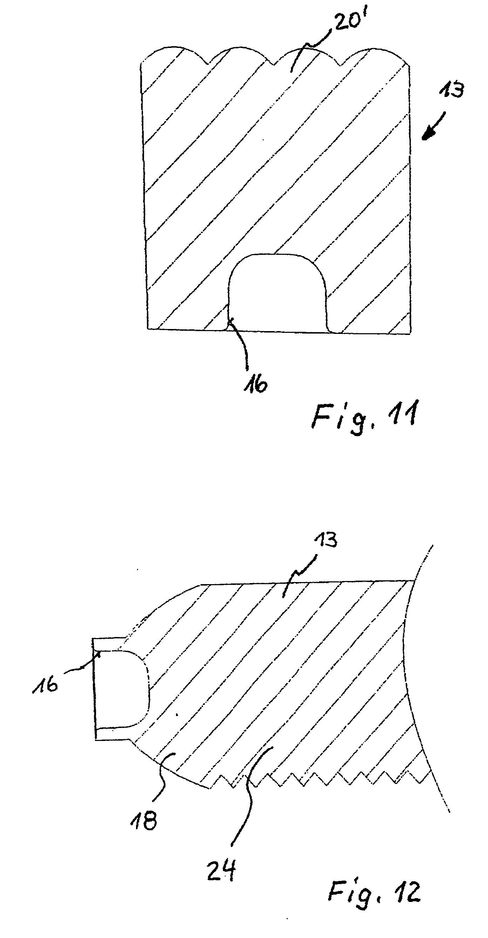

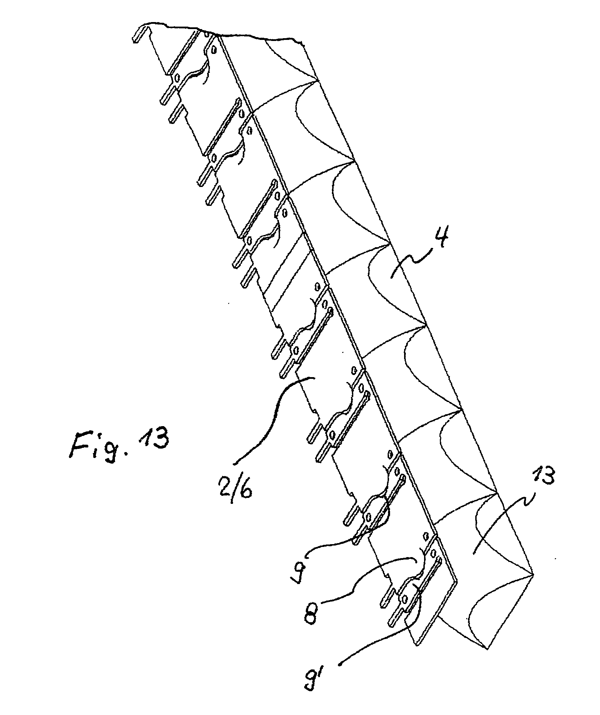

Die Optikelemente 13 können beispielsweise einen lichtsammelnden Reflektor 18 und eine dem Reflektor 18 in Abstrahlrichtung 19 vorgelagerte lichtverteilende Streuoptik 20 aufweisen. Der Reflektor 18 ist dabei so gestaltet, dass er das vom lichtemittierenden Halbleiterchip 3, der sich im Brennpunkt des optischen Systems befindet, emittierte Licht umlenkt und mittels Totalreflexion oder Verspiegelung sammelt. Als Formen sind beispielsweise Paraboloide, Koni oder Ellipsoide möglich. Die Lichtverteilung kann durch die direkt auf der Körperoberseite angebrachte Streuoptik 20 (s. Figur 7) erfolgen. Die Lichtverteilung kann aber auch direkt über einen entsprechend geformten Freiformreflektor 21 (s. Figur 8) erfolgen. Auch ist es möglich, eine konvexe Kissenoptik 22 (s. Figur 9) oder eine konkave Kissenoptik 23 (s. Figur 10) auf die Reflektoren 13 aufzubringen. Es ist aber auch möglich, auf einen Reflektor zu verzichten und nur das direkte vom lichtemittierenden Halbleiterchip 3 abgestrahlte Licht zu nutzen und eine Streuoptik 20' (s. Figur 11) zu verwenden. Weiterhin ist es möglich, entsprechende Optikelemente 13 für Lichtleitsysteme wie z.B. Prismenstäbe 24 aufzubauen.

Zur Montage werden die lichtemittierenden Halbleiterchips 3 mittels Die-Bonden auf die großflächigen Kathoden 8 aufgebracht und über die Drahtbondungen 10 durch Draht-Bonden (Wire-Bonden) mit den Anoden 9' der benachbarten Basiselemente 7' verbunden. Nunmehr wird der Optikkörper 4 so auf die Leiterbahnstruktur 2 aufgesetzt, dass sich die Konturen 15, 15', 15", 15'" des Frames 6 in die Ausformungen 16 der Optikelemente 13 einpassen und die Basiselemente 7, 7' gegenüber den Optikelementen 13 justiert werden. Anschließend werden der Frame 6 und der Optikkörper 4 bzw. dessen Optikelemente 13 mit der zunächst flüssigen transparenten Masse 14 miteinander verfugt und einem Aushärteprozess unterzogen.

## Patentansprüche

1. Leuchte für Fahrzeuge mit einer Mehrzahl von lichtemittierenden Halbleiterchips, die auf einer Leiterbahnstruktur angeordnet sind und denen in Abstrahlrichtung ein gemeinsamer Optikkörper vorgelagert ist, **dadurch gekennzeichnet, dass** der Optikkörper (4) fest mit der Leiterbahnstruktur (2) verbunden und als tragendes Element für die Halbleiterchips (3) und deren Leiterbahnstruktur (2) ausgebildet ist.

2. Leuchte nach Anspruch 1, **dadurch gekennzeichnet, dass** die Leiterbahnstruktur (2) als ein metallischer Frame (6) mit einer Mehrzahl von Basiselementen (7,7')ausgebildet ist, auf denen die lichtemittierenden Halbleiterchips (3) elektrisch kontaktiert sind.

3. Leuchte nach Anspruch 2, **dadurch gekennzeichnet, dass** das Basiselement (7) eine großflächige Kathode (8) aufweist, auf der der lichtemittierende Halbleiterchip (3) aufgebracht ist, und eine anschließende Anode (9) aufweist, die den lichtemittierenden Halbleiterchip (3) der Nachbarkathode (8') kontaktiert und die bei thermischer Ausdehnung ein die Ausdehnung ausgleichendes Bauteil bildet.

4. Leuchte nach Anspruch 3, **dadurch gekennzeichnet, dass** die Anode (9,9') über eine ein Gelenk bildende Verdünnung (11) mit der Kathode (8,8') verbunden ist.

5. Leuchte nach einem der Ansprüche 2 bis 4, **dadurch gekennzeichnet, dass** der Optikkörper (4) eine Mehrzahl von Optikelementen (13) aufweist denen jeweils ein Basiselement (7,7') mit lichtemittierendem Halbleiterchip (3) zugeordnet ist, und dass die lichtemittierenden Halbleiterchips (3) jeweils in einem Brennpunkt der Optikelemente (13) angeordnet sind.

6. Leuchte nach einem der Ansprüche 1 bis 5, **dadurch gekennzeichnet, dass** die Leiterbahnstruktur (2) und der Optikkörper (4) durch eine transparente Masse (14) miteinander verfugt sind.

7. Leuchte nach Anspruch 6, **dadurch gekennzeichnet, dass** die transparente Masse (14) mit einem Konvertierungsmittel versetzt ist.

8. Leuchte nach Anspruch 6, **dadurch gekennzeichnet, dass** zwischen der transparenten Masse (14) und den Optikelementen (13) eine Schicht aus einem Konvertierungsmittel angeordnet ist.

9. Leuchte nach einem der Ansprüche 4 bis 8, **dadurch gekennzeichnet, dass** der metallische Frame (6) im Bereich seiner Basiselemente (7,7') eine Kontur (15,15') aufweist, die in die zugeordneten Optikelemente (13) so eingreift, dass die Basiselemente (7,7') gegenüber den Optikelementen (13) einpassbar und ausgerichtet miteinander verfügbar sind.

10. Verfahren zur Herstellung einer Leuchte für Fahrzeuge mit einer Mehrzahl von auf einer Leiterbahnstruktur angeordneten lichtemittierenden Halbleiterchips und einem in Abstrahlrichtung vorgelagerten Optikkörper, **dadurch gekennzeichnet, dass** die lichtemittierenden Halbleiterchips (3) auf der Leiterbahnstruktur (2) kontaktiert und durch Einpassen von Bereichen der Leiterbahnstruktur (2) in entsprechende Optikelemente (13) des Optikkörpers (4) ausgerichtet werden, und dass durch eine transparente Masse (14) die Leiterbahnstruktur (2) fest mit dem Optikkörper (4) verbunden wird.

11. Verfahren nach Anspruch 10, **dadurch gekennzeichnet, dass** die lichtemittierenden Halbleiterchips (3) mittels Die-Bonden und Draht-Bonden mit der als Frame (6) ausgebildeten Leiterbahnstruktur (2) kontaktiert werden.

12. Verfahren nach Anspruch 10 oder 11, **dadurch gekennzeichnet, dass** die lichtemittierenden Halbleiterchips (3) mittels Flip-Chip-Technik mit der als Frame (6) ausgebildeten Leiterbahnstruktur (2) kontaktiert werden.

13. Verfahren nach einem der Ansprüche 10 bis 12, **dadurch gekennzeichnet, dass** das Ausrichten von Leiterbahnstruktur (2) und Optikelementen (13) durch Einpassen einer räumlichen Kontur (15,15') von Basiselementen (7,7') der Leiterbahnstruktur (2) mit kontaktierten Halbleiterchips (3) in die entsprechenden Optikelemente (13) erfolgt.

14. Verfahren nach einem der Ansprüche 10 bis 12, **dadurch gekennzeichnet, dass** das Ausrichten von Leiterbahnstruktur (2) und Optikelementen (13) mit Hilfe von Justagedornen (17,17') von Basiselementen (7,7') der Leiterbahnstruktur (2) mit kontaktierten Halbleiterchips (3) durchgeführt wird, die in entsprechende Ausformungen (16) der Optikelemente (13) greifen.

15. Verfahren nach einem der Ansprüche 10 bis 14, **dadurch gekennzeichnet, dass** die Leiterbahnstruktur (2) mit dem Optikkörper (4) vergossen wird oder durch den Optikkörper (4) umspritzt wird.
